(19) Europäisches Patentamt
European Patent Office
Office européen des brevets

(11) **EP 1 931 031 A1**

(12) **EUROPEAN PATENT APPLICATION**
published in accordance with Art. 153(4) EPC

(43) Date of publication:
**11.06.2008 Bulletin 2008/24**

(51) Int Cl.:
*H03K 17/95* (2006.01)    *G01B 7/00* (2006.01)

(21) Application number: **06797135.8**

(86) International application number:
**PCT/JP2006/317175**

(22) Date of filing: **31.08.2006**

(87) International publication number:
**WO 2007/026799 (08.03.2007 Gazette 2007/10)**

(84) Designated Contracting States:
**DE FR GB**

(30) Priority: **02.09.2005  JP 2005254482
29.08.2006  JP 2006232267
29.08.2006  JP 2006232268**

(71) Applicant: **Azuma Systems Co., Ltd.
Kumagaya-shi, Saitama 360-0201 (JP)**

(72) Inventor: **YAMAKAWA, Kazuhiro
Kounosu-shi, Saitama 365-0039 (JP)**

(74) Representative: **Faulkner, Thomas John et al
FJ Cleveland
40-43 Chancery Lane
London WC2A 1JQ (GB)**

(54)    **PROXIMITY SENSOR AND PROXIMITY DETECTION METHOD**

(57)    A proximity sensor for detecting proximity of a metal, **characterized in that** a driving signal is output to a resonant circuit that includes a capacitor connected to a detecting coil, and the proximity of the metal is detected based on a phase shift of freely oscillating waves that are attenuatedly output from the resonant circuit after an output of the driving signal is stopped, the proximity sensor includes a driving signal output means that outputs the driving signal to the resonant circuit; and a phase shift measuring means that measures a phase shift of oscillating waves that is involved in the proximity of the metal based on the freely oscillating waves that are attenuatedly output from the resonant circuit after the output of the driving signal is stopped.

Fig. 1

**Description**

Technical Field

The present disclosure relates to a proximity sensor detecting a proximity of a metal such as a proximity switch, a displacement sensor, a distance sensor, a material sensor, a coin sensor, a metallic sphere sensor and the like and a proximity detecting method. In particular, the present disclosure relates to a proximity sensor and a proximity detecting method capable of being applied to a high-precision displacement sensor detecting a displacement of a metal with high accuracy and dramatically enhancing its cost performance.

Background Art

A proximity sensor that detects proximity of a metal has been widely used (see Japanese Patent No. 2550621, for example). The proximity sensor of this kind includes not only a proximity switch that is used as a non-contact micro switch but also a displacement sensor that detects a displacement of a metal, a distance sensor that detects a proximity distance to a metal, a material sensor that determines a material of a metal, a coin sensor that detects a passage of a coin (hard currency, a token, and the like), and a metallic sphere sensor that detects a penetration of a metallic sphere (a pachinko ball and the like).

The proximity sensor of Japanese Patent No. 2550621 is a high frequency oscillation type proximity switch that is provided with a high frequency oscillation circuit that includes a detecting coil. The proximity sensor determines a proximity or material of a metal, taking advantage of the fact that an oscillation amplitude or oscillation frequency of the high frequency oscillation circuit varies when a metal is proximate to the detecting coil. More specifically, the oscillation amplitude or oscillation frequency of the high frequency oscillation circuit varies according to not only a proximity distance to the metal but also properties of a material of the metal (differences in magnetic permeability, electric conductivity, and the like). A proximity switch in a manner of measuring amplitude can well detect proximity of a magnetic metal (iron and the like). A proximity sensor in a manner of measuring a frequency can well detect proximity of a non-magnetic metal (aluminum and the like). A proximity sensor that has a function for both manners above can well detect proximity of a magnetic metal and a non-magnetic metal and also well determine a material of a metal.

Disclosure of the Invention

Problems to be Solved by the Invention

In measuring a frequency change according to proximity of a metal and maintaining a high frequency oscillation; however, the conventional proximity sensor in the manner of measuring a frequency measures a subtle phase shift. A complicated circuit such as a synchronous detection circuit is thus required, which leads to a problem in that the proximity sensor can be remarkably expensive as compared with a proximity sensor in the manner of measuring amplitude. Although the subtle phase shift can be detected by a digital circuit, an exceedingly high-speed counter or CPU is required. Consequently, the cost may become even higher.

Measuring an amplitude change according to proximity of a metal and maintaining a high frequency oscillation, on the other hand, the proximity sensor in the manner of measuring amplitude measures a subtle change in amplitude. Accordingly, there is a problem that a circuit configuration becomes complicated, which results in cost overrun. Although the subtle amplitude change can be detected accurately by a digital circuit, an analog to digital (A/D) converter with high resolution is required and thus the cost may become even higher. The present disclosure solves these problems as well as other problems and is also able to achieve various advantages.

Means for Solving the problems

The disclosure addresses an exemplary aspect, in which a proximity sensor detects a proximity of a metal, including a resonant circuit that is composed by connecting a capacitor to a detecting coil, wherein a driving signal is output to the resonant circuit and the proximity of the metal is detected based on a phase shift and/or an amplitude change of freely oscillating waves that are attenuatedly output from the resonant circuit after the driving signal is stopped being output. According to the proximity sensor, the phase shift and/or the amplitude change of oscillating waves that is/are involved in the proximity of the metal can be measured accurately with a simple circuit configuration. As for the freely oscillating waves that are attenuatedly output from the resonant circuit, the phase shift or the amplitude change of oscillating waves that is involved in the proximity of the metal occurs clearly. Moreover, the phase shift in freely oscillating waves is accumulated by the number of the oscillating waves. The amplitude change in the freely oscillating wave is maintained to some extent in an amount of change in amplitude even if the oscillating waves are attenuated.

The change can be captured as a larger rate of change at a more attenuated side where the entire amplitude is smaller. As a result, the phase shift or the amplitude change can be measured with high precision even by an inexpensive circuit.

In another exemplary aspect, the proximity sensor includes a driving signal outputting means that outputs a driving signal to the resonant circuit; and a phase shift measuring means that measures a phase shift of oscillating waves that is involved in the proximity of the metal based on freely oscillating waves that are attenuatedly output from the resonant circuit after the driving signal outputting means stops its signal output. According to the proximity sensor, the present disclosure can be implemented as a proximity sensor in the manner of measuring a phase shift (the manner of measuring a frequency).

In another exemplary aspect, the phase shift measuring means includes a freely oscillating wave counting means that counts the number of freely oscillating waves that are attenuatedly output from the resonant circuit after the driving signal outputting means stops its signal output; and a counting time measuring means that measures a time until the freely oscillating wave counting means counts a predetermined number of freely oscillating waves. According to the proximity sensor, the accumulated phase shift can be measured with high accuracy by an inexpensive digital circuit.

In another exemplary aspect, the phase shift measuring means repeats in a predetermined number of times a regression operation of counting the number of freely oscillating waves that are output from the resonant circuit after the driving signal outputting means stops its signal output, and of making the driving signal outputting means output a driving signal at the time of counting a predetermined number of freely oscillating waves, and thereby amplifies the phase shift of freely oscillating waves. According to the proximity sensor, measurement accuracy of the phase shift that is involved in a proximity of the metal can be significantly improved only by increasing the number of times of the regression operation, without rendering the circuit configuration complicated.

In another exemplary aspect, the phase shift measuring means includes a time measuring means that starts clocking in response to a first output of the driving signal by the driving signal outputting means and finishes clocking at the moment when a predetermined number of freely oscillating waves are output from the resonant circuit after the predetermined number of times of the regression operation is finished. According to the proximity sensor, the amplified phase shift can be measured with high accuracy by an inexpensive digital circuit.

In another exemplary aspect, the proximity sensor includes a driving signal outputting means that outputs a driving signal to the resonant circuit; and an amplitude measuring means that measures an amplitude change of oscillating waves that is involved in the proximity of the metal based on freely oscillating waves that are attenuatedly output from the resonant circuit after the driving signal outputting means stops its signal output. According to the proximity sensor, the present disclosure can be implemented as a proximity sensor in the manner of measuring amplitude.

In another exemplary aspect, the amplitude measuring means includes a freely oscillating wave counting means that counts the number of freely oscillating waves that are attenuatedly output from the resonant circuit after the driving signal outputting means stops its signal output; and a measured value capturing means that captures a measured amplitude value of a freely oscillating wave after the freely oscillating wave counting means counts a predetermined number of freely oscillating waves. According to the proximity sensor, the amplitude change of the oscillating waves that is involved in the proximity of the metal can be measured accurately with a simple circuit configuration.

In another exemplary aspect, the resonant circuit is a series resonant circuit that is composed by serially connecting the capacitor to the detecting coil. According to the proximity sensor, a voltage Q times (Q: a quality factor of the resonant circuit) as large as a source voltage at the maximum can be applied to the detecting coil by the action of the series resonant circuit. A freely oscillating wave of large amplitude thus can be output from the resonant circuit. The number of freely oscillating waves counted thus can be increased so that not only is measurement accuracy further enhanced but also resistance to noise is improved.

In another exemplary aspect, the driving signal outputting means forcedly oscillates the resonant circuit by a plurality of driving pulse signals, and thereafter stops outputting of the driving signals. According to the proximity sensor, amplitude of a forcedly oscillating wave can be larger compared to the case when the resonant circuit is forcedly oscillated by a single driving pulse signal. In particular, if several shots of the driving pulse signals are output so that the amplitude of the forcedly oscillating wave can maximized, amplitude of a freely oscillating wave that is output from the resonant circuit after the driving signals are stopped being output can be larger, so that measurement accuracy can be further enhanced.

In another exemplary aspect, the phase shift measuring means directly inputs an output signal of the resonant circuit without an amplifier. According to the proximity sensor, the circuit configuration is simpler so that a further cost reduction becomes possible.

In another exemplary aspect, the driving signal outputting means and the phase shift measuring means are arranged in a one-chip microcomputer. According to the proximity sensor, a high performance proximity sensor can be constituted only by the resonant circuit (the detecting coil and the capacitor) and the one-chip microcomputer. Consequently, a cost reduction can be further realized.

In another exemplary aspect, a proximity detecting method for detecting a proximity of a metal includes outputting a driving signal to a resonant circuit that is composed by connecting a capacitor to a detecting coil; and detecting the proximity of the metal based on a phase shift and/or an amplitude change of freely oscillating waves that are attenuatedly output from the resonant circuit after the driving signal is stopped being output. According to the proximity sensor, the phase shift and/or the amplitude change of oscillating waves that is/are involved in the proximity of the metal can be measured accurately with a simple circuit configuration. As for the freely oscillating waves that are attenuatedly output from the resonant circuit, the phase shift or the amplitude change of oscillating waves that is involved in the proximity of the metal occurs clearly. Moreover, the phase shift in freely oscillating waves is accumulated by the number of the oscillating waves. The amplitude change in the freely oscillating wave is maintained to some extent in an amount of change in amplitude even if the oscillating waves are attenuated. The change can be captured as a larger rate of change at a more attenuated side where the entire amplitude is smaller. As a result, the phase shift or the amplitude change can be measured with high precision even by an inexpensive circuit.

In another exemplary aspect, the proximity detecting method includes outputting a driving signal to the resonant circuit; counting the number of freely oscillating waves that are attenuatedly output from the resonant circuit after the driving signal is stopped being output; measuring a time until a predetermined number of freely oscillating waves is counted; and measuring a phase shift of the oscillating waves that is involved in the proximity of the metal based on the measured time. According to the proximity sensor, the accumulated phase shift can be measured with high accuracy by an inexpensive digital circuit.

In another exemplary aspect, the proximity detecting method includes, when outputting the driving signal to the resonant circuit and measuring the phase shift of oscillating waves that is involved in the proximity of the metal based on freely oscillating waves that are attenuatedly output from the resonant circuit after the driving signal is stopped being output, repeating in a predetermined number of times of a regression operation of counting the number of freely oscillating waves that are output from the resonant circuit after the driving signal is stopped being output and outputting a driving signal to the resonant circuit at the time of counting a predetermined number of freely oscillating waves, and thereby amplifies the phase shift of the freely oscillating waves. According to the proximity sensor, measurement accuracy of the phase shift that is involved in a proximity of the metal can be significantly improved only by increasing the number of times of the regression operation, without rendering the circuit configuration complicated.

In another exemplary aspect, the proximity detecting method includes starting clocking in response to the first output of the driving signal to the resonant circuit; finishing clocking at the moment when a predetermined number of freely oscillating waves is output from the resonant circuit after the predetermined number of times of the regression operation is finished; and measuring the phase shift of the oscillating waves that is involved in the proximity of the metal based on a result of the clocking. According to the proximity sensor, the amplified phase shift can be measured with high accuracy by an inexpensive digital circuit.

In another exemplary aspect, the proximity detecting method includes outputting a driving signal to the resonant circuit; counting the number of freely oscillating waves that are attenuatedly output from the resonant circuit after the driving signal is stopped being output; and capturing a measured amplitude value in a freely oscillating wave after counting a predetermined number of freely oscillating waves. According to the proximity sensor, the amplitude change of the oscillating waves that is involved in the proximity of the metal can be measured accurately with a simple circuit configuration.

In another exemplary aspect, the resonant circuit is a series resonant circuit that is composed by serially connecting the capacitor to the detecting coil. According to the proximity sensor, a voltage Q times (Q: a quality factor of the resonant circuit) as large as a source voltage at the maximum can be applied to the detecting coil by the action of the series resonant circuit. A freely oscillating wave of large amplitude thus can be output from the resonant circuit. The number of freely oscillating waves counted thus can be increased so that not only is measurement accuracy further enhanced but also resistance to noise is improved.

In another exemplary aspect, the proximity detecting method includes forcedly oscillating the resonant circuit by a plurality of driving pulse signals, and thereafter stops outputting of the driving signals. According to the proximity sensor, amplitude of a forcedly oscillating wave can be larger compared to the case when the resonant circuit is forcedly oscillated by a single driving pulse signal. In particular, if several shots of the driving pulse signals are output so that the amplitude of the forcedly oscillating wave can maximized, amplitude of a freely oscillating wave that is output from the resonant circuit after the driving signals are stopped being output can be larger, so that measurement accuracy can be further enhanced.

Effects of the Invention

According to the present disclosure, as above, the phase shift and the amplitude change of oscillating waves that are involved in the proximity of the metal can be measured accurately with a simple circuit configuration. More specifically, as for the freely oscillating waves that are attenuatedly output from the resonant circuit, the phase shift and the amplitude change of oscillating waves that are involved in the proximity of the metal occurs clearly. Moreover, the phase shift of freely oscillating waves is accumulated by the number of the oscillating waves. The amplitude change of the freely oscillating wave, even if being attenuated, is maintained to some extent in an amount of change in amplitude and can be captured as a larger rate of change at a more attenuated side where the entire amplitude is smaller. As a result, the phase shift and the amplitude change can be measured with high accuracy even by an inexpensive circuit.

Brief Description of the Drawings

Fig. 1 is a block diagram showing a configuration of a proximity sensor in accordance with a first embodiment of the present disclosure.
Fig. 2 is a flow chart showing a processing procedure of a one-chip microcomputer in accordance with the first embodiment of the present disclosure.
Fig. 3 is an explanatory diagram showing a waveform of a driving pulse signal (Point a) and an oscillating waveform of a resonant circuit (Point b) in accordance with the first embodiment of the present disclosure.
Fig. 4 is an explanatory diagram showing, in an enlarged manner, a tenth-odd freely oscillating wave in accordance with the first embodiment of the present disclosure.
Fig. 5 is an explanatory diagram showing a phase shift when a metal is in proximity (7 millimeters) to a detecting coil in accordance with the first embodiment of the present disclosure.
Fig. 6 is an explanatory diagram showing a phase shift when the metal is in proximity (3 millimeters) to the detecting coil in accordance with the first embodiment of the present disclosure.
Fig. 7 is an explanatory diagram showing a relationship between a freely oscillating waveform (Point b) and an output of a comparator (Point c) in accordance with the first embodiment of the present disclosure.
Fig. 8 is an enlarged view showing an output of the comparator when the metal is not in proximity to the detecting coil in accordance with the first embodiment of the present disclosure.
Fig. 9 is an explanatory diagram showing an output of the comparator when the metal is in proximity (7 millimeters) to the detecting coil in accordance with the first embodiment of the present disclosure.
Fig. 10 is an explanatory diagram showing an output of the comparator when the metal is in proximity (3 millimeters) to the detecting coil in accordance with the first embodiment of the present disclosure.
Fig. 11 is a graph showing a relationship between proximity distance to the metal and a phase shift in accordance with the first embodiment of the present disclosure.
Fig. 12 is an explanatory diagram showing an action of amplifying the phase shift by a regression operation in accordance with a second embodiment of the present disclosure.
Fig. 13 is a flow chart showing a processing procedure of a one-chip microcomputer in accordance with the second embodiment of the present disclosure.
Fig. 14 is a flow chart showing a processing procedure of the one-chip microcomputer in accordance with a third embodiment of the present disclosure.
Fig. 15 is an explanatory diagram showing amplitude changes of freely oscillating waves (simplified waveforms for an explanation of operation) that are involved in proximity of a metal in accordance with the third embodiment of the present disclosure.

Description of Symbols

1: Proximity sensor
2: Resonant circuit
3: One-chip microcomputer
4: Peak hold
C: Capacitor
L: Detecting coil

Best Mode for Carrying Out the Invention

[First Embodiment]

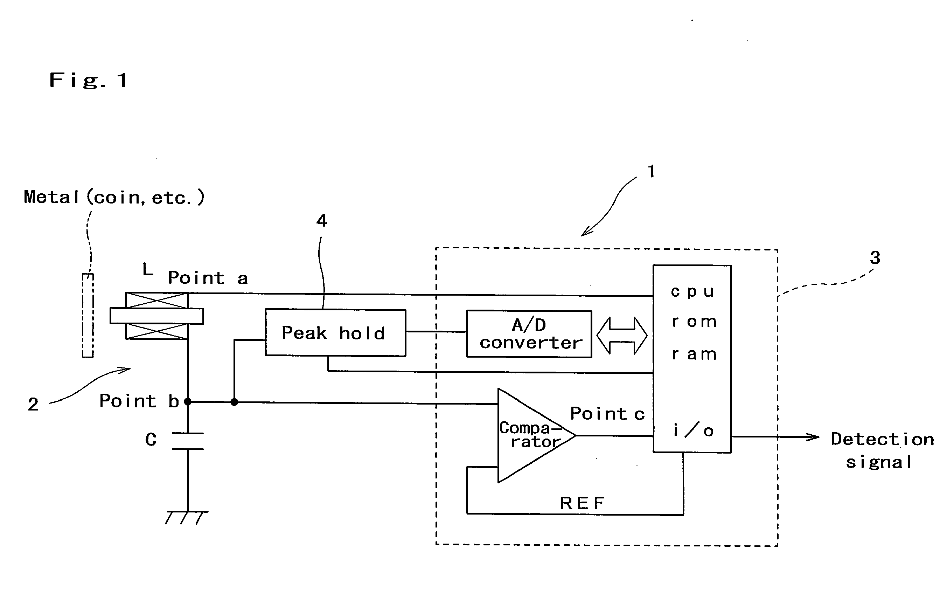

Next, a first embodiment of the present disclosure is described based on the drawings. Numeral 1 shown in Fig. 1 is a proximity sensor that detects proximity of a metal. The proximity sensor 1 includes a resonant circuit 2, a one-chip microcomputer 3, and a peak hold 4 (see Fig. 1). The resonant circuit 2 includes a capacitor C connected to a detecting coil L and is driven by a driving signal outputting means that is configured within the one-chip microcomputer 3. The one-chip microcomputer 3 houses a central processing unit (CPU), a read-only memory (ROM), a random access memory (RAM), an input/output device (I/O), a comparator, an analog to digital (A/D) converter, and the like. The one-chip microcomputer 3 operates as a driving signal outputting means, a phase shift measuring means, and an amplitude measuring means by writing a predetermined processing procedure (program) on the ROM.

The phase shift measuring means is configured so to measure a phase shift of oscillating waves that is involved in the proximity of a metal based on freely oscillating waves that are attenuatedly output from the resonant circuit 2 after the driving signal outputting means stops its signal output. The phase shift of the oscillating waves that is involved in the proximity of the metal thus can be measured accurately with a simple circuit configuration. More specifically, as for the freely oscillating waves that are attenuatedly output from the resonant circuit 2, not only does the phase shift of the oscillating waves that is involved in the proximity of the metal occur clearly, but the phase shift is also accumulated by the number of the oscillating waves. The phase shift can thus be measured with high accuracy with an inexpensive digital circuit that does not have a high speed counter. Moreover, because of the detecting manner of this kind, the detecting coil L can be used as an exciting coil as well. Accordingly, the number of coils is reduced so that a further cost reduction can be accomplished.

In the first embodiment, the phase shift measuring means includes a freely oscillating wave counting means that counts the number of freely oscillating waves that are attenuatedly output from the resonant circuit 2 after the driving signal outputting means stops its signal output and a counting time measuring means that measures a time until the freely oscillating wave counting means counts a predetermined number n of freely oscillating waves. The accumulated phase shift thus can be measured with high accuracy by an inexpensive digital circuit. While preferably being set to 2 to 100, the number n of freely oscillating waves counted can be set optionally according to required measurement accuracy and performance (price) of a coil. The proximity sensor 1 with high cost performance thus can be provided. For example, when price is given priority, an inexpensive coil can be used that is larger in attenuation of a freely oscillating wave, and the number n of freely oscillating waves counted can be set to about 2 to 10. When accuracy is given priority, an expensive coil can be used that is smaller in attenuation of a freely oscillating wave, and the number n of freely oscillating waves counted can be set to about 10 to 100.

The resonant circuit 2 is preferably a series resonant circuit in which the capacitor C is serially connected to the detecting coil L. A voltage Q times (8 times, for example) as large as a source voltage (5V, for example) at the maximum thus can be applied to the detecting coil L by the action of the series resonant circuit. Consequently, a freely oscillating wave of a large amplitude can be output from the resonant circuit 2. The number n of freely oscillating waves counted can be increased so that not only is measurement accuracy further enhanced but also resistance to noise is improved. Because freely oscillating waves of a large amplitude can be directly input to the one-chip microcomputer 3 (the phase shift measuring means) without an amplifier, the circuit configuration is simpler, which makes a further cost reduction possible.

The maximum voltage $V_{LMAX}$ that is applied to the detecting coil L can be obtained by the following equation, Formula 1, wherein: $\omega_0$ represents a resonant angular frequency; L represents an inductance of the detecting coil L; R represents a resistance of the detecting coil L; C represents a capacitance of the capacitor C; $V_s$ represents a source voltage; and Q represents a quality factor of the resonant circuit.

Formula 1:

$$\omega_0 = \frac{1}{\sqrt{LC}}$$

$$Q = \frac{\omega_0 L}{R}$$

$$V_{LMAX} = Q \cdot V_s$$

When the resonant circuit 2 is forcedly oscillated by a driving pulse signal, the driving signal outputting means of the first embodiment forcedly oscillates the resonant circuit 2 by a plurality of driving pulse signals and then stops outputting the driving signals. An amplitude of a forcedly oscillating wave thus can be larger compared to the case when the resonant circuit 2 is forcedly oscillated by a single shot driving pulse signal. In particular, if several shots (6 shots, for example) of the driving pulse signals are output at a predetermined resonant frequency such that the amplitude of the forcedly oscillating wave is maximized, an amplitude of a freely oscillating wave that is output from the resonant circuit 2 after the driving signals are stopped being output can be larger, whereupon measurement accuracy can be further enhanced.

A resonant frequency f at which the resonant circuit 2 is forcedly oscillated can be obtained by the following equation, Formula 2, wherein: L represents an inductance of the detecting coil L; and C represents a capacitance of the capacitor C.

Formula 2:

$$f = \frac{1}{2\pi\sqrt{LC}}$$

The amplitude measuring means measures amplitude of a freely oscillating wave that is output from the resonant circuit 2. More specifically, into the one-chip microcomputer 3 via the A/D converter the amplitude measuring means reads a peak value that has been held by the peak hold 4. Amplitude and a phase shift of the freely oscillating waves thus can be measured. A material of a metal can also be determined with high accuracy.

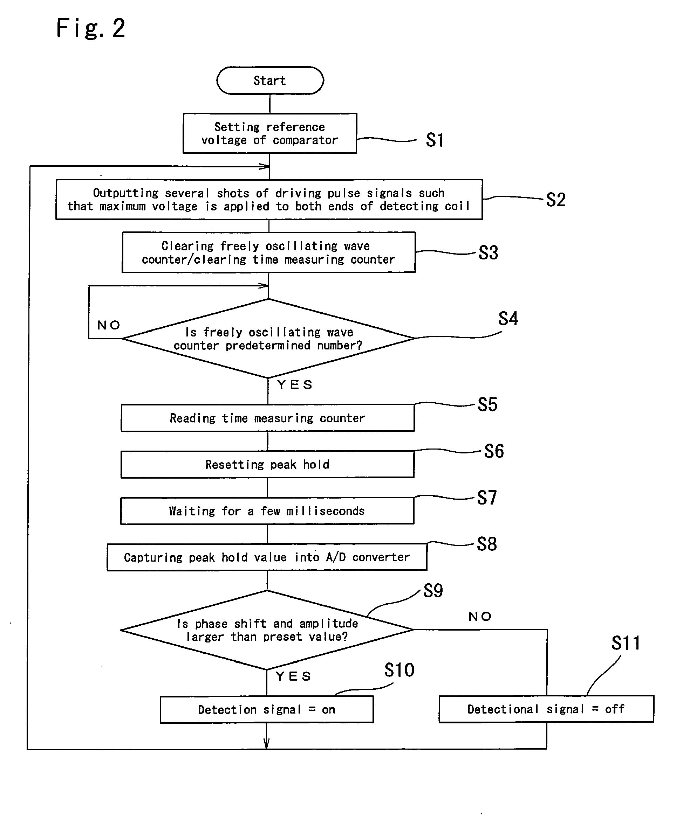

Next, a processing procedure on the one-chip microcomputer 3 is described with reference to FIG. 2. The one-chip microcomputer 3 first sets a reference voltage of the comparator (S1). After that, the one-chip microcomputer 3 repeats driving signal outputting processing (S2: the driving signal outputting means), phase shift measuring processing (S3 to S5: the phase shift measuring means), amplitude measuring processing (S6 to S8: the amplitude measuring means), and proximity determining processing (S9 to S11).

The driving signal outputting processing outputs several shots of driving pulse signals at a predetermined resonant frequency with respect to the resonant circuit 2 so that the amplitude of the forcedly oscillating wave can be maximized. After the driving signals are stopped being output, the phase shift measuring processing clears a freely oscillating wave counter and a time measuring counter. Counting the number of freely oscillating waves that are attenuatedly output from the resonant circuit 2, the phase shift measuring processing measures a time until the freely oscillating wave counter reaches to the predetermined number n. After the predetermined number n of freely oscillating waves is counted, the amplitude measuring processing resets the peak hold 4, waits for a predetermined time (a few milliseconds), and reads in a peak hold value (a measured amplitude value) via the A/D converter. The proximity determining processing compares both the measured phase shift (value of the time measuring counter) and the measured amplitude (peak hold value) with a preset intended determination value, and thereafter outputs a detection signal (ON/OFF).

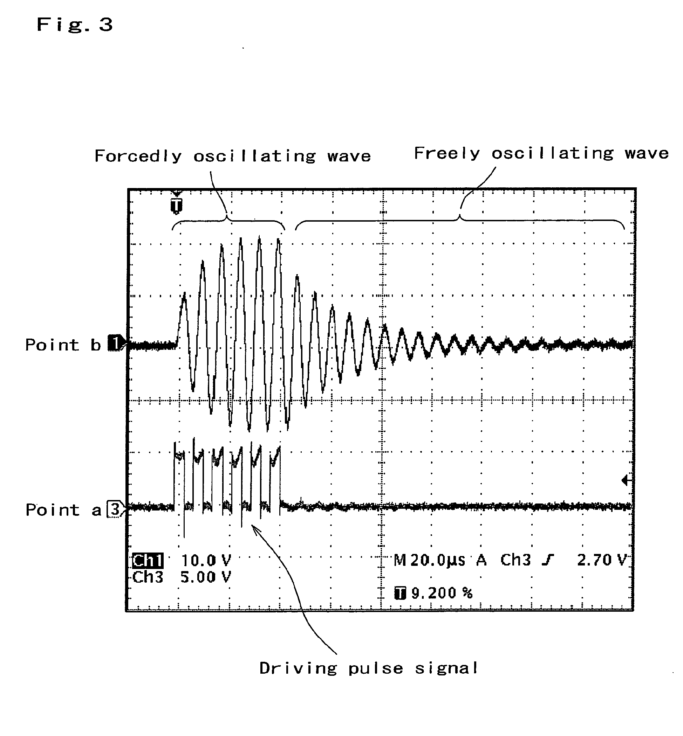

Next, operation of the proximity sensor 1 of the first embodiment is described with reference to Figs. 3 to 11. Fig. 3 is an explanatory diagram that shows a waveform of the driving pulse signal (Point a) and an oscillating waveform of the resonant circuit (Point b). The one-chip microcomputer 3 outputs a driving pulse signal at a predetermined voltage (5V, for example) in order to forcedly oscillate the resonant circuit 2 (see Fig. 3). At this time, in the first embodiment, because several shots (6 shots, for example) of the driving pulse signals are output at a predetermined resonant frequency, the maximum voltage (40V, for example) is applied to the detecting coil L. After the driving pulse signals are stopped being output, a plurality of freely oscillating waves are attenuatedly output from the resonant circuit 2.

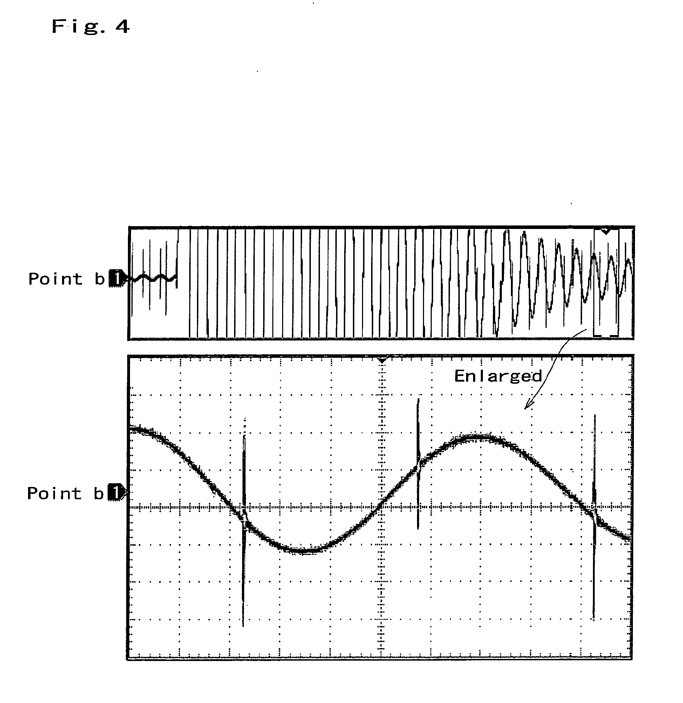

As shown in Figs. 4, 5, and 6, the freely oscillating wave that is output from the resonant circuit 2, even if being a tenth-odd, maintains sufficient amplitude in order to be detected even. When a metal (a coin: a non-magnetic metal) becomes proximate to the detecting coil L, a magnetic flux that is generated from the detecting coil L magnetically interferes with the metal in proximity. Then a phase of the freely oscillating waves is advanced. The phase shift of the freely oscillating waves that is involved in the proximity of the metal not only occurs more clearly as compared with that of forcedly oscillating waves, but is also accumulated by the number of freely oscillating waves. The phase shift thus can be measured with high accuracy even by a low speed counter.

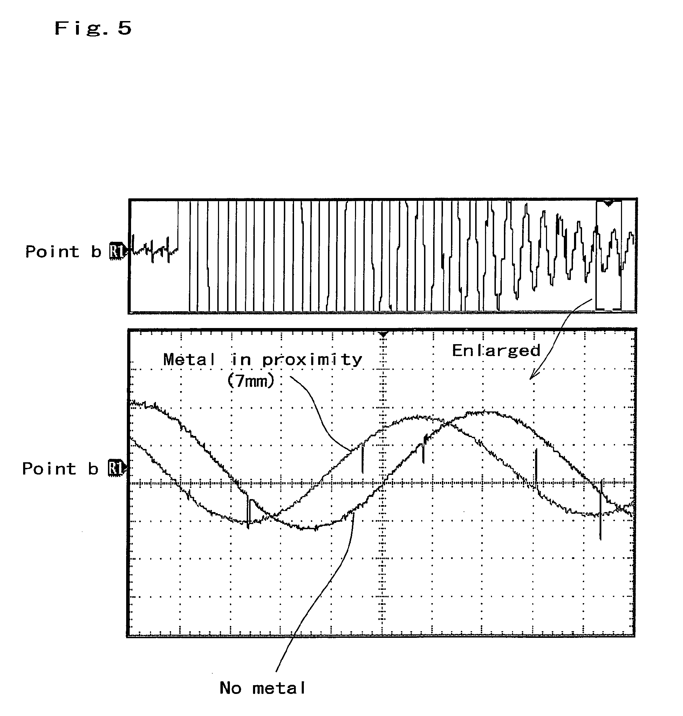

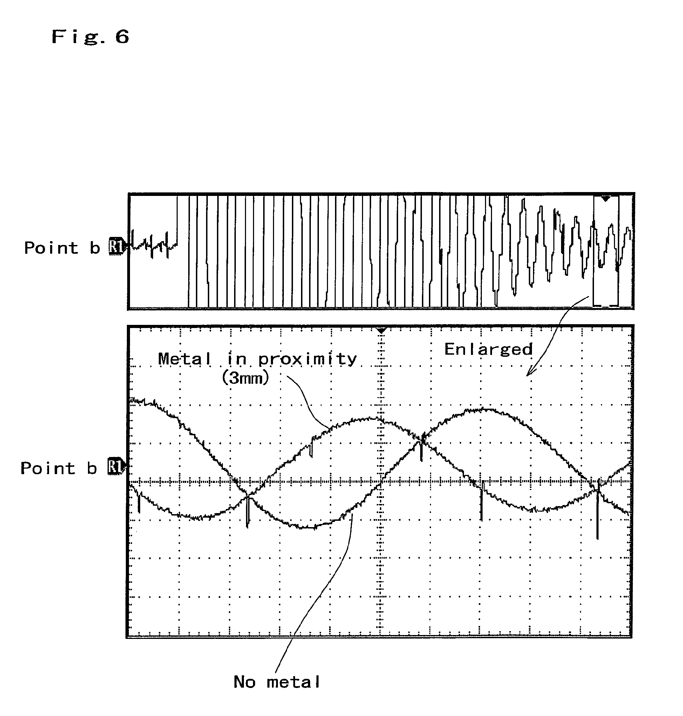

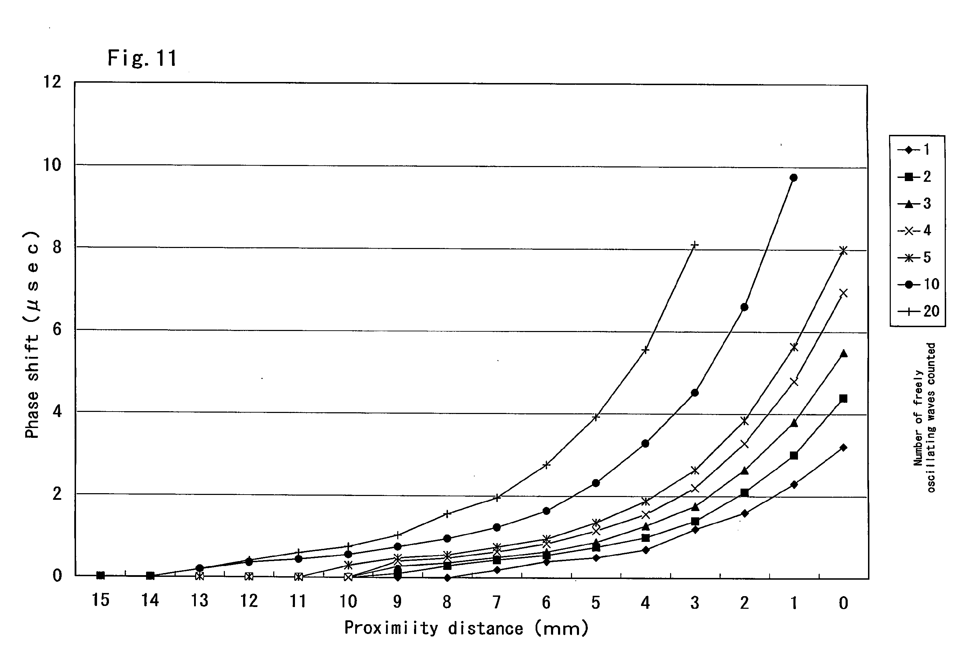

As shown in Figs. 5 and 6, the phase shift of the freely oscillating waves becomes larger as the metal is closer to the detecting coil L. A distance between the detecting coil L and the metal can be measured with high accuracy based on the phase shift of the freely oscillating waves. Fig. 11 illustrates a relationship between a proximity distance to the metal (mm) and the phase shift (μsec). The phase shift of the freely oscillating waves becomes larger as the metal is closer to the detecting coil L. In particular, the phase shift is added by 10 to 20 times in data of the phase shift of the tenth to twentieth freely oscillating waves. A distance measurement (a displacement measurement) with exceedingly high accuracy is thus achieved.

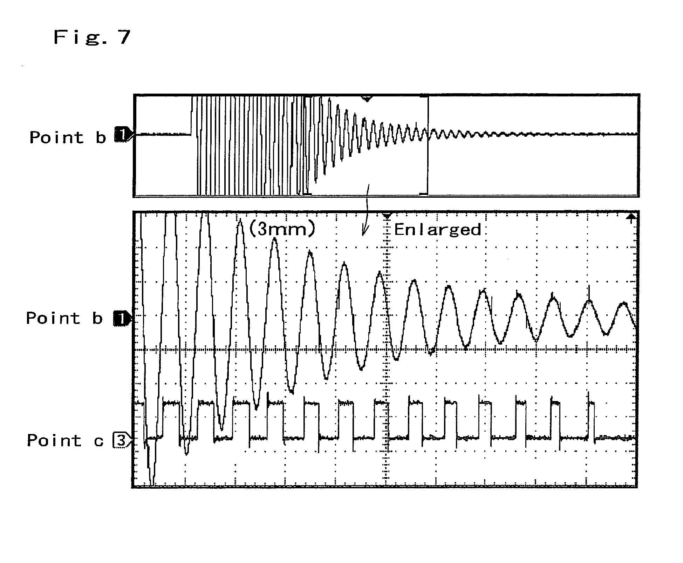

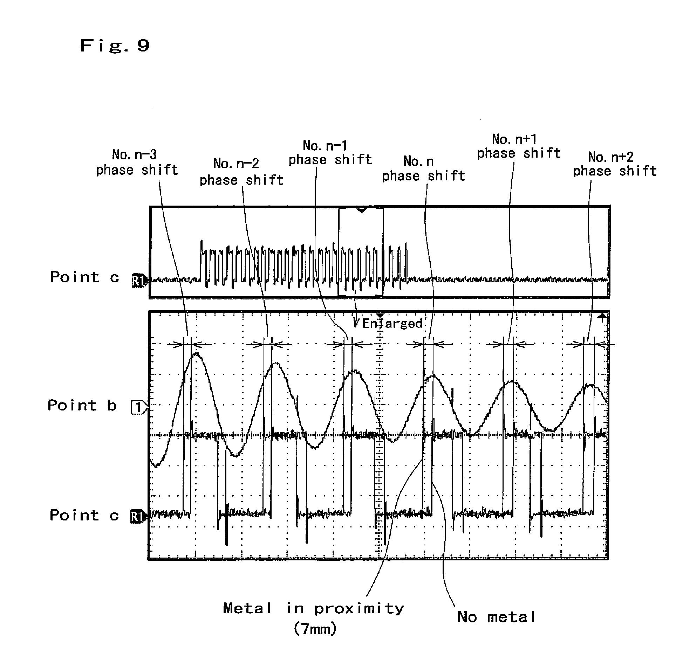

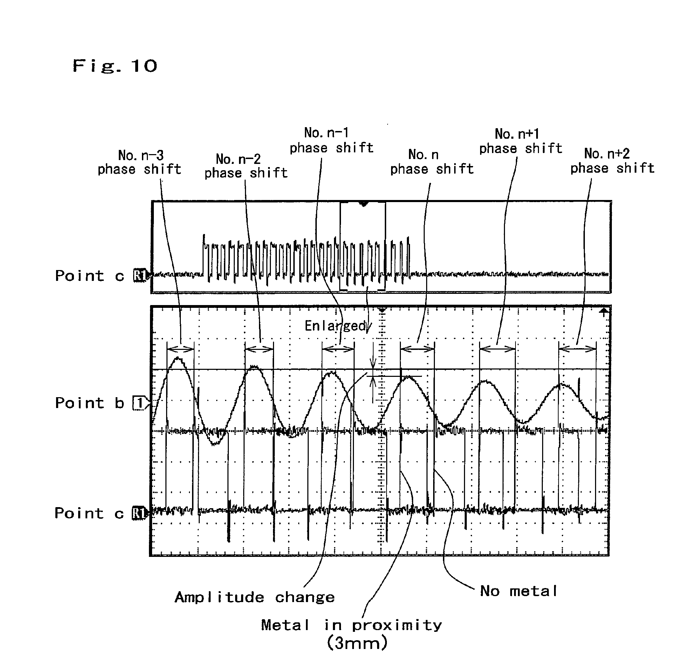

As shown in Figs. 7 to 10, the freely oscillating wave that is output from the resonant circuit 2 maintains sufficient amplitude in order to be detected, even if being a tenth-odd. The wave thus can be transformed into a clear rectangular wave by the comparator. When a metal becomes proximate to the detecting coil L, a phase of the output waveform of the comparator is advanced. As is obvious from Figs. 9 and 10, the phase shift that is involved in the proximity of the metal is more accumulated as the number of freely oscillating waves is increased, so that measurement is facilitated.

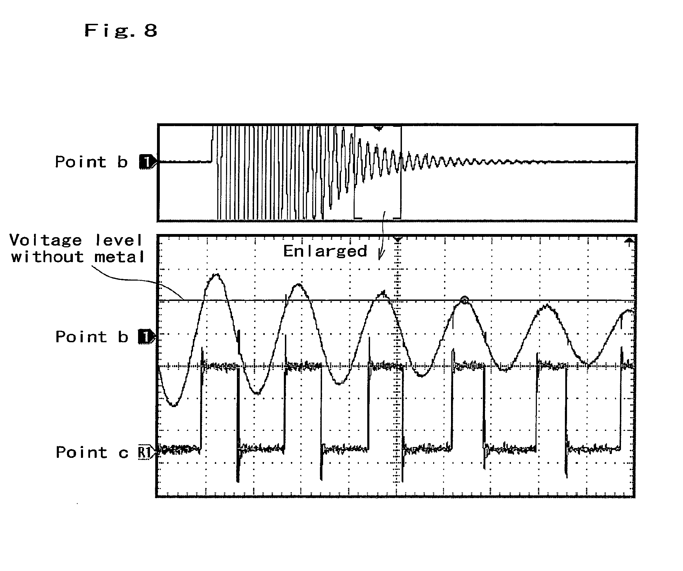

As shown in Figs. 8, 9, and 10, the amplitude of the freely oscillating wave varies with the proximity of the metal. By measuring this amplitude change, the proximity of the metal is doubly detected. Not only can a more reliable proximity determination be possible, but a material determination of the metal can also be made based on combination patterns of the phase shift and the amplitude change.

The proximity sensor 1 of the first embodiment configured as above includes a resonant circuit 2 that includes a capacitor C connected to a detecting coil L, a driving signal outputting means that outputs a driving signal with respect to the resonant circuit 2, and a phase shift measuring means that measures a phase shift of oscillating waves that is involved in a proximity of a metal based on freely oscillating waves that are attenuatedly output from the resonant circuit 2 after the driving signal outputting means stops its signal output. Therefore, the phase shift of the oscillating waves that is involved in the proximity of the metal can be measured accurately with a simple circuit configuration. That is, in terms of freely oscillating waves that are attenuatedly output from the resonant circuit 2, the phase shift of the oscillating waves that is involved in the proximity of the metal occurs clearly, and also is accumulated by the number of oscillating waves. Therefore, the phase shift can be measured with high accuracy even by an inexpensive digital circuit without a high speed counter.

According to the detecting manner of this kind, the detecting coil L can be also used as an exciting coil. The number of coils is thus reduced such that a further cost reduction can be accomplished.

Furthermore the phase shift measuring means includes a freely oscillating wave counting means that counts the number of freely oscillating waves that are attenuatedly output from the resonant circuit 2 after the driving signal outputting means stops its signal output and a counting time measuring means that measures a time until the freely oscillating wave counting means counts a predetermined number n of freely oscillating waves. Therefore, the accumulated phase shift can be measured with high accuracy by an inexpensive digital circuit.

The number n of freely oscillating waves counted is set within 2 to 100 and also can be set optionally based on required measurement accuracy and performance (price) of a coil. If price is given preference, for example, an inexpensive coil can be used that is larger in attenuation of a freely oscillating wave. The number n of freely oscillating waves counted can be set to about 2 to 10. If accuracy is given preference, an expensive coil can be used that is smaller in attenuation of a freely oscillating wave. The number n of freely oscillating waves counted can be set to about 10 to 100. The proximity sensor 1 with high cost performance can be provided.

The resonant circuit 2 is a series resonant circuit that includes the capacitor C connected to the detecting coil L. Because a voltage Q times as large as a source voltage at the maximum can be applied to the detecting coil L by the action of the series resonant circuit, a freely oscillating wave of a large amplitude can be output from the resonant circuit 2. The number n of freely oscillating waves counted can be increased. Measurement accuracy is further enhanced and resistance to noise is improved.

The driving signal outputting means forcedly oscillates the resonant circuit 2 by a plurality of driving pulse signals, and then stops outputting the driving signals. An amplitude of a forcedly oscillating wave can be larger compared to the case when the resonant circuit 2 is forcedly oscillated by a single shot driving pulse signal. If several shots of driving pulse signals are output such that the amplitude of the forcedly oscillating wave is maximized, then a large amplitude of a freely oscillating wave can be output from the resonant circuit 2 after the driving signals are stopped being output. The measurement accuracy can be further enhanced.

Because the phase shift measuring means directly inputs an output signal of the resonant circuit 2 without being via an amplifier, the circuit configuration can be simpler. A further cost reduction can be possible.

Because both the driving signal outputting means and the phase shift measuring means are arranged into the one-chip microcomputer 3, the proximity sensor 1 with high performance can include only the resonant circuit 2 (the detecting coil L and the capacitor C) and the one-chip microcomputer 3.

Because the amplitude measuring means for measuring an amplitude of a freely oscillating wave that is output from the resonant circuit 2 is provided, a material of a metal can also be determined with high accuracy based on the amplitude and the phase shift of freely oscillating waves.

[Second Embodiment]

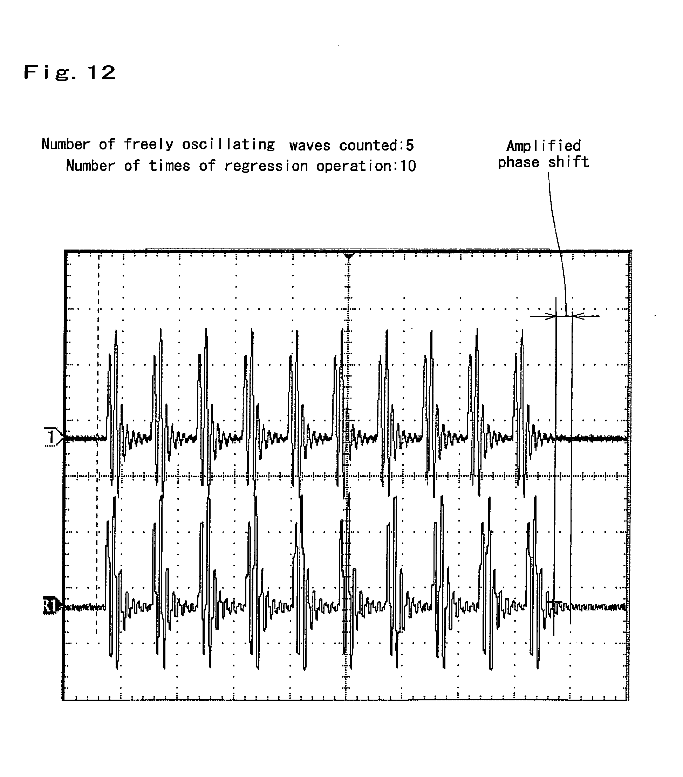

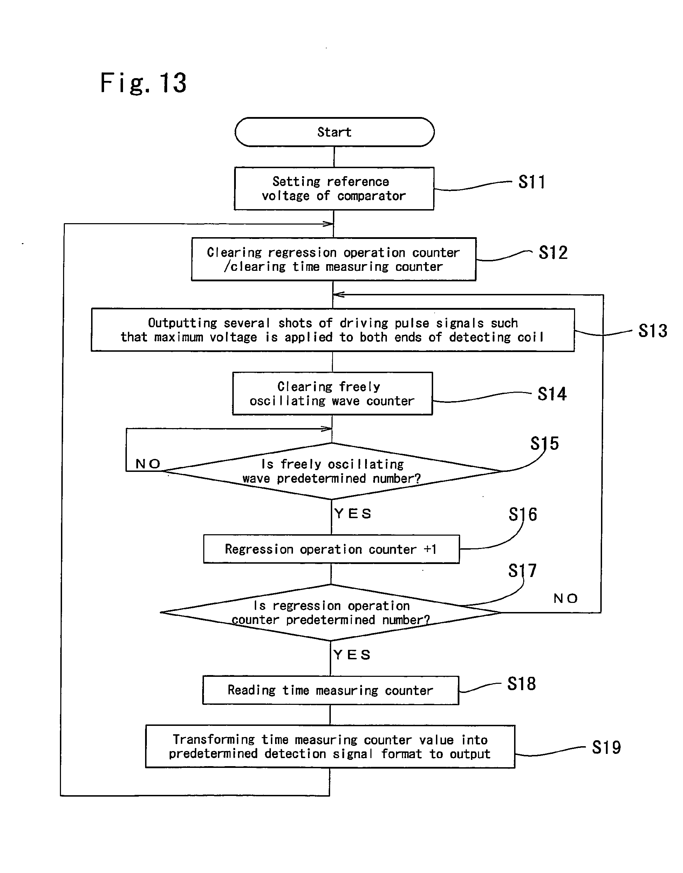

Next, a proximity sensor 1 of a second embodiment of the present disclosure is described with reference to Figs. 12 and 13. The proximity sensor 1 of the second embodiment differs from that of the first embodiment in that a phase shift of freely oscillating waves is amplified by repeating a regression operation a predetermined number of times in order to measure the phase shift of oscillating waves that is involved in the proximity of a metal based on freely oscillating waves that are attenuatedly output from the resonant circuit 2 after a signal output to the resonant circuit 2 is stopped. The regression operation counts the number of freely oscillating waves that are output from the resonant circuit 2 after the signal output to the resonant circuit 2 is stopped, and then outputs a driving signal to the resonant circuit 2 at the time of counting a predetermined number of freely oscillating waves.

By this means, measurement accuracy of the phase shift that is involved in the proximity of the metal can be significantly improved only by increasing the number of the regression operations, without rendering the circuit configuration complicated. For example, the phase shift measuring means includes a time measuring means that starts clocking in response to a first output of driving signals of the driving signal outputting means and finishes clocking at the moment when a predetermined number of freely oscillating waves are output from the resonant circuit 2 after the predetermined number of times of the regression operation is finished. The amplified phase shift thus can be measured with high accuracy with an inexpensive digital circuit.

The number of freely oscillating waves counted and the number of times the regression operation can be set optionally according to required measurement accuracy and performance (price) of a coil. When cost performance is given priority, for example, a relatively inexpensive coil can be used that is larger in attenuation of a freely oscillating wave or a relatively inexpensive microcomputer that is slower in operating speed. The number of freely oscillating waves counted should be set to about 2 to 10 and the number of times of the regression operation to about 5 to 10. When measurement accuracy is given priority, a relatively expensive coil can be used that is smaller in attenuation of a freely oscillating wave or a relatively expensive microcomputer that is higher in operation speed is used. The number of freely oscillating waves counted should be set to not less than 10 and the number of times of the regression operation not less than 10.

An action of amplifying the phase shift by the regression operation is described with reference to Fig. 12. Waveforms shown in Fig. 12 are output waveforms of the resonant circuit 2 when a regression operation is repeated 10 times. The regression operation outputs two shots of driving pulse signals in order to forcedly oscillate the resonant circuit 2 and newly outputs two other shots of driving pulse signals to the resonant circuit 2 at the time of counting the fifth freely oscillating wave that are attenuatedly output from the resonant circuit 2.

As shown in Fig. 12, the waveform at a top side illustrates a case when a metal is closer than a case illustrated by the waveform at a bottom side. Repeating a predetermined number of times the regression operation of outputting the driving signals to the resonant circuit 2 at the time of counting the predetermined number of freely oscillating waves amplifies the phase shift of freely oscillating waves. As a result, measurement accuracy of the phase shift involved in the proximity of the metal can be significantly improved only by increasing the number of times of the regression operation, without rendering the circuit configuration complicated. More specifically, with the use of a timer that starts clocking in response to the first output of driving signals by the driving signal outputting means and finishes clocking at the moment when the predetermined number of freely oscillating waves are output from the resonant circuit 2 after the predetermined number of times of the regression operation is ended, the phase shift that is involved in the proximity of the metal can be measured with high accuracy.

Next, a processing procedure in the one-chip microcomputer 3 is described with reference to Fig. 13. The one-chip microcomputer 3 firstly sets a reference voltage of a comparator (S11). After that, the one-chip microcomputer 3 repeats counter clearing processing (S12), driving signal outputting processing (S13: the driving signal outputting means), and phase shift measuring processing (S13 to S19: the phase shift measuring means).

As shown in Fig. 13, the counter clearing processing is processing of clearing a regression operation counter and a time measuring counter. The driving signal outputting processing is processing of outputting several shots of driving pulse signals at a predetermined resonant frequency with respect to the resonant circuit 2 such that an amplitude of a forcedly oscillating wave is maximized. The phase shift measuring processing clears a freely oscillating wave counter after the driving signals are stopped being output (S14). The phase shift measuring processing then counts the number of freely oscillating waves that are attenuatedly output from the resonant circuit 2 and also judges whether the counted number reaches a predetermined number (S15). When a result of the judgment is YES, the phase shift measuring processing increments the regression operation counter (S16) and judges whether the number of times of the regression operation reaches a predetermined number (S17). When a result of the judgment is NO, the phase shift measuring processing returns to the driving signal outputting processing and repeats S13 to S17. After the number of times of the regression operation reaches the predetermined number (S18: the time measuring means), the phase shift measuring processing reads in a value of the time measuring counter, transforms the read value of the time measuring counter into a predetermined detection signal format (a proximity distance signal, for example), and outputs the transformed read value of the time measuring counter (S19).

The proximity sensor 1 of the second embodiment configured as above includes a resonant circuit 2 that includes a capacitor C connected to a detecting coil L, a driving signal outputting means that outputs a driving signal to the resonant circuit 2, and a phase shift measuring means that measures a phase shift of oscillating waves that is involved in the proximity of the metal based on freely oscillating waves that are attenuatedly output from the resonant circuit 2 after the driving signal outputting means stops its signal output.

The phase shift measuring means repeats in a predetermined number of times the regression operation of counting the number of freely oscillating waves that are output from the resonant circuit 2 after the driving signal outputting means stops its signal output and making the driving signal outputting means output a driving signal at the time of counting a predetermined number of freely oscillating waves. By this means, the phase shift of the freely oscillating waves is amplified so that the phase shift of oscillating waves that is involved in the proximity of the metal can be measured accurately with a simple circuit configuration. More specifically, as for the freely oscillating waves that are attenuatedly output from the resonant circuit 2, the phase shift of oscillating waves that is involved in the proximity of the metal not only clearly occurs but also is accumulated by the number of oscillating waves. Therefore, the phase shift can be measured with high accuracy even by an inexpensive digital circuit that does not have a high speed counter. Moreover, the phase shift of freely oscillating waves is amplified by repeating a predetermined number of times the regression operation of outputting a driving signal to the resonant circuit 2 at the time of counting a predetermined number of freely oscillating waves. Accordingly, measurement accuracy of the phase shift that is involved in the proximity of the metal can be significantly improved only by increasing the number of times of the regression operation, without rendering the circuit configuration complicated.

The phase shift measuring means includes a time measuring means that starts clocking in response to the first output of driving signals by the driving signal outputting means and, after the predetermined number of times of the regression operation is finished, finishes clocking at the moment when a predetermined number of freely oscillating waves is output from the resonant circuit 2. Consequently, the amplified phase shift can be measured with high accuracy by an inexpensive digital circuit.


[Third Embodiment]

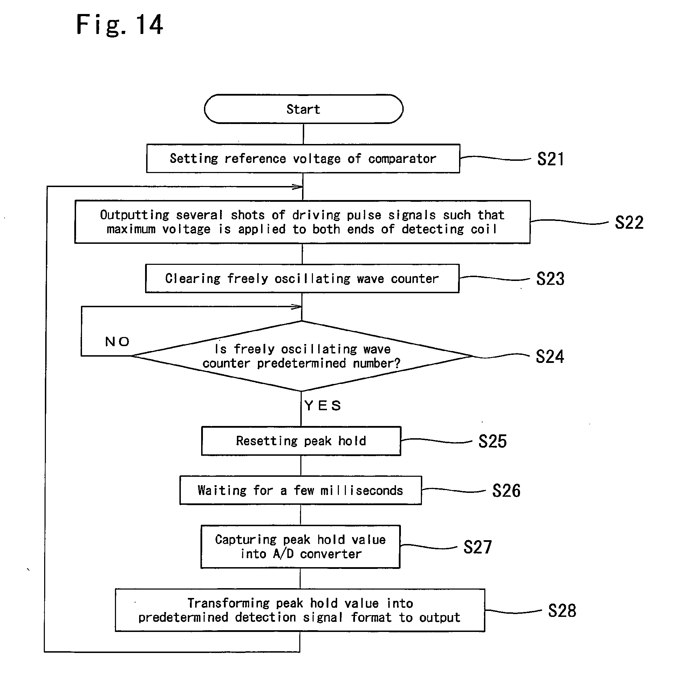

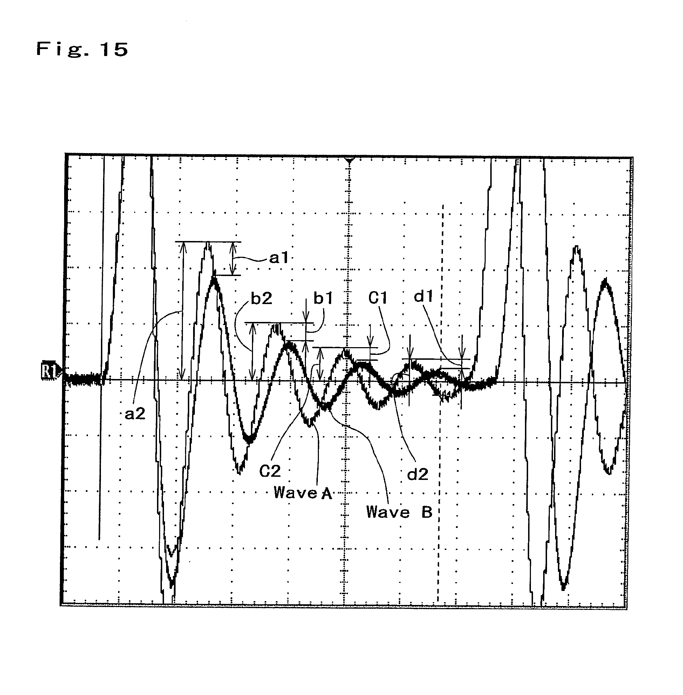

Next, a proximity sensor 1 of a third embodiment of the present disclosure is described with reference to Figs. 14 and 15. The proximity sensor 1 of the third embodiment is different from the sensors 1 of the foregoing embodiments in that a phase shift measuring means is not provided and only an amplitude measuring means is provided. The amplitude measuring means of the proximity sensor 1 of the third embodiment measures an amplitude change of oscillating waves that is involved in the proximity a the metal based on freely oscillating waves that are attenuatedly output from the resonant circuit 2 after the driving signal outputting means stops its signal output. The amplitude change of oscillating waves that is involved in the proximity of the metal can be measured accurately with a simple circuit configuration. More specifically, as for the freely oscillating waves that are attenuatedly output from the resonant circuit 2, not only does the amplitude change of the oscillating waves that is involved in the proximity of the metal clearly occur but also an amount of change in amplitude is maintained even if the oscillating waves are attenuated. The change can be captured as a larger rate of change at a more attenuated side where the entire amplitude is smaller. Consequently, the amplitude change can be measured with high accuracy even by an inexpensive circuit.

The amplitude measuring means of the third embodiment includes a freely oscillating wave counting means that counts the number of freely oscillating waves that are attenuatedly output from the resonant circuit 2 after the driving signal outputting means stops its signal output and a measured value capturing means that captures a measured amplitude value of a freely oscillating wave after the freely oscillating wave counting means counts a predetermined number of freely oscillating waves. More specifically, the amplitude measuring means resets the peak hold 4 after counting a predetermined number of freely oscillating waves. After a predetermined time from the reset, into the one-chip microcomputer 3 via the A/D converter the amplitude measuring means captures a peak value (a measured amplitude value) that is held by the peak hold 4. The number of freely oscillating waves counted can be set optionally according to required measurement accuracy and performance (price) of a coil. When price is given priority, for example, an inexpensive coil can be used that is larger in attenuation of a freely oscillating wave. The number of freely oscillating waves counted should be set to about 2 to 5. When accuracy is given priority, an expensive coil can be used that is smaller in attenuation of a freely oscillating. The number of freely oscillating waves counted should be set to not less than 5.

Next, a processing procedure in the one-chip microcomputer 3 is described with reference to Fig. 14. The one-chip microcomputer 3 first sets a reference voltage of the comparator (S21). After that, the one-chip microcomputer 3 repeats driving signal outputting processing (S22: the driving signal outputting means) and amplitude measuring processing (S23 to S27: the amplitude measuring means).

As shown in Fig. 14, the driving signal outputting processing outputs several shots of driving pulse signals at a predetermined resonant frequency to the resonant circuit 2 such that an amplitude of a forcedly oscillating wave is maximized (S22). The amplitude measuring means clears the freely oscillating wave counter after the driving signals are stopped being output (S23) and counts the number of freely oscillating waves that are attenuatedly output from the resonant circuit 2. When the freely oscillating wave counter reaches a predetermined number (S24: the freely oscillating wave counting means), the amplitude measuring means resets the peak hold (S25). After waiting for a predetermined time (a few milliseconds, for example) (S26), the amplitude measuring means reads in a peak hold value (a measured amplitude value) via the A/D converter (S27: the measured value capturing means). And then, the amplitude measuring means transforms the read peak hold value into a predetermined detection signal format (a proximity distance signal, for example) and output the transformed read peak hold value (S28).

Next, an operation of the proximity sensor 1 of the third embodiment is described with reference to Fig. 15. When a driving pulse signal at a predetermined voltage (5V, for example) is output from the one-chip microcomputer 3 in order to forcedly oscillate the resonant circuit 2, a plurality of freely oscillating waves are attenuatedly output from the resonant circuit 2 after the driving pulse signal is stopped being output. When a metal is proximate to the detecting coil L, a magnetic flux that is generated from the detecting coil L magnetically interferes with the metal in proximity. Then amplitude of the freely oscillating waves varies and a phase shift of the freely oscillating waves is caused. Not only does the amplitude change of the freely oscillating waves that is involved in the proximity of the metal occur more clearly as compared with that of forcedly oscillating waves but also an amount of change in amplitude is maintained to some extent even if the oscillating waves are attenuated. The change can be captured as a larger rate of change at a more attenuated side where the entire amplitude is smaller.

Operation is described based on the simplified waveforms shown in Fig. 5, for example. Amounts of changes in amplitude of freely oscillating waves (differences in amplitude between Wave A and Wave B: $a_1 > b_1 > c_1 > d_1$) that are involved in the proximity of the metal are smaller as the freely oscillating waves are more attenuated. Because reduction rates of the overall amplitude ($a_2 > b_2 > c_2 > d_2$) due to the attenuation are larger, the change can be captured as a larger rate of change ($d_1/d_2 > c_1/c_2 > b_1/b_2 > a_1/a_2$) at a more attenuated side.

The proximity sensor 1 of the third embodiment as configured above includes a resonant circuit 2 that is composed by connecting a capacitor C to a detecting coil L, a driving signal outputting means that outputs a driving signal to the resonant circuit 2, and an amplitude measuring means that measures an amplitude change of oscillating waves that is involved in the proximity of the metal based on freely oscillating waves that are attenuatedly output from the resonant circuit 2 after the driving signal outputting means stops its signal output. The amplitude change of freely oscillating waves involved in the proximity of the metal can be measured accurately with a simple circuit configuration. More specifically, as for the freely oscillating waves that re attenuatedly output from the resonant circuit 2, not only does the amplitude change of the oscillating waves that is involved in the proximity of the metal occur clearly but also an amount of change in amplitude is maintained to some extent even if the oscillating waves are attenuated. Accordingly, the change can be captured as a larger rate of change at a more attenuated side where the entire amplitude is smaller. As a result, the amplitude change can be measured with high accuracy even by an inexpensive circuit.

The amplitude measuring means includes a freely oscillating wave counting means that counts the number of freely oscillating waves that are attenuatedly output from the resonant circuit 2 after the driving signal outputting means stops its signal output and a measured value capturing means that captures a measured amplitude value of a freely oscillating wave after the freely oscillating wave counting means counts a predetermined number of freely oscillating waves. As a result, the amplitude change of the oscillating waves that is involved in the proximity of the metal can be measured accurately with a simple circuit configuration.

Industrial Applicability

The present disclosure can be applied to a proximity sensor such as a proximity switch that is used as a non-contact micro switch, a displacement sensor that detects a displacement of a metal, a distance sensor that detects a proximity distance to a metal, a material sensor that determines a material of a metal, a coin sensor that detects a passage of a coin (hard currency, a token and the like), and a metallic sphere sensor that detects a penetration of a metallic sphere (a pachinko ball and the like), and to a proximity detecting method. In particular, the present disclosure can be suitably used for a high-precision displacement sensor for detecting a displacement of a metal with high accuracy.

**Claims**

1. A proximity sensor that detects proximity of a metal, comprising:

    a resonant circuit that is composed by connecting a capacitor to a detecting coil,

    wherein a driving signal is output to the resonant circuit and the proximity of the metal is detected based on a phase shift and/or an amplitude change of freely oscillating waves that are attenuatedly output from the resonant circuit after the driving signal is stopped being output.

2. The proximity sensor according to claim 1, further comprising:

    a driving signal outputting means that outputs a driving signal to the resonant circuit; and
    a phase shift measuring means that measures a phase shift of oscillating waves that is involved in the proximity of the metal based on freely oscillating waves that re attenuatedly output from the resonant circuit after the driving signal outputting means stops its signal output.

3. The proximity sensor according to claim 2, wherein the phase shift measuring means comprises:

   a freely oscillating wave counting means that counts the number of freely oscillating waves that are attenuatedly output from the resonant circuit after the driving signal outputting means stops its signal output; and
   a counting time measuring means that measures a time until the freely oscillating wave counting means counts a predetermined number of freely oscillating waves.

4. The proximity sensor according to claim 2 or 3, wherein the phase shift measuring means repeats in a predetermined number of times a regression operation of counting the number of freely oscillating waves that are attenuatedly output from the resonant circuit after the driving signal outputting means stops its signal output and making the driving signal outputting means output a driving signal at the time of counting a predetermined number of freely oscillating waves, thereby amplifying the phase shift of the freely oscillating waves.

5. The proximity sensor according to claim 4, wherein the phase shift measuring means comprises a time measuring means that starts clocking in response to a first output of the driving signal of the driving signal outputting means and finishes clocking at the moment when a predetermined number of freely oscillating waves is output from the resonant circuit after the predetermined number of times of the regression operation is finished.

6. The proximity sensor according to any one of claims 1 to 5, further comprising:

   a driving signal outputting means that outputs a driving signal to the resonant circuit; and
   an amplitude measuring means that measures an amplitude change of oscillating waves that is involved in the proximity of the metal based on freely oscillating waves that are attenuatedly output from the resonant circuit after the driving signal outputting means stops its signal output.

7. The proximity sensor according to claim 6, wherein the amplitude measuring means comprises:

   a freely oscillating wave counting means that counts the number of freely oscillating waves that are attenuatedly output from the resonant circuit after the driving signal outputting means stops its signal output; and
   a measured value capturing means that captures a measured amplitude value of a freely oscillating wave after the freely oscillating wave counting means counts a predetermined number of freely oscillating waves.

8. The proximity sensor according to any one of the claims 1 to 7, wherein the resonant circuit is a series resonant circuit that is composed by serially connecting the capacitor to the detecting coil.

9. The proximity sensor according to any one of claims 2 to 8, wherein the driving signal outputting means forcedly oscillates the resonant circuit by a plurality of driving pulse signals and then stops outputting the driving signals.

10. The proximity sensor according to any one of claims 2 to 9, wherein the phase shift measuring means directly inputs an output signal by the resonant circuit without being via an amplifier.

11. The proximity sensor according to any one of claims 2 to 10, wherein the driving signal outputting means and the phase shift measuring means are arranged in a one-chip microcomputer.

12. A proximity detecting method for detecting proximity of a metal, comprising:

   outputting a driving signal to a resonant circuit that is composed by connecting a capacitor to a detecting coil; and
   detecting the proximity of the metal based on a phase shift and/or an amplitude change of freely oscillating waves that are attenuatedly output from the resonant circuit after the driving signal is stopped being output.

13. The proximity detecting method according to claim 12, further comprising:

   outputting a driving signal to the resonant circuit;
   counting the number of freely oscillating waves that are attenuatedly output from the resonant circuit after the driving signal is stopped being output;
   measuring a time until a predetermined number of freely oscillating waves is counted; and

measuring a phase shift of oscillating waves that is involved in the proximity of the metal based on the measured time.

**14.** The proximity detecting method according to claim 12 or 13, further comprising:

when outputting the driving signal to the resonant circuit and measuring the phase shift of the oscillating waves that is involved in the proximity of the metal based on the freely oscillating waves that are attenuatedly output from the resonant circuit after the driving signal is stopped being output,
repeating in a predetermined number of times a regression operation of counting the number of freely oscillating waves that are output from the resonant circuit after the driving signal is stopped being output and outputting a driving signal to the resonant circuit at the time of counting a predetermined number of freely oscillating waves, and thereby amplifying the phase shift of the freely oscillating waves.

**15.** The proximity detecting method according to claim 14, further comprising:

starting clocking in response to a first output of the driving signal to the resonant circuit;
finishing clocking at the moment when a predetermined number of freely oscillating waves is output from the resonant circuit after the predetermined number of times of the regression operation is finished; and
measuring the phase shift of the oscillating waves that is involved in the proximity of the metal based on a result of the clocking.

**16.** The proximity detecting method according to any one of claims 12 to 15, further comprising:

outputting a driving signal to the resonant circuit;
counting the number of freely oscillating waves that are attenuatedly output from the resonant circuit after the driving signal is stopped being output; and
capturing a measured amplitude value of a freely oscillating wave after a predetermined number of freely oscillating waves is counted.

**17.** The proximity detecting method according to any one of claims 12 to 16,
wherein the resonant circuit is a series resonant circuit that is composed by serially connecting the capacitor to the detecting coil.

**18.** The proximity detecting method according to any one of claims 12 to 17, further comprising forcedly oscillating the resonant circuit by a plurality of driving pulse signals, and thereafter stopping outputting of the driving signals.

Fig. 1

# Fig. 2

```
                    ( Start )
                        │
        ┌───────────────────────────────┐
        │   Setting reference           │──── S1
        │   voltage of comparator       │
        └───────────────────────────────┘
                        │
   ┌────────────────────┤
   │    ┌──────────────────────────────────────────────────────────┐
   │    │  Outputting several shots of driving pulse signals such   │──── S2
   │    │  that maximum voltage is applied to both ends of detecting coil│
   │    └──────────────────────────────────────────────────────────┘
   │                    │
   │        ┌───────────────────────────────────┐
   │        │   Clearing freely oscillating wave │──── S3
   │        │   counter/clearing time measuring counter │
   │        └───────────────────────────────────┘
   │                    │
   │        ┌───────────┤
   │   NO   ◇───────────────────────────────◇──── S4
   │   ┌────     Is freely oscillating wave
   │   │         counter predetermined number?
   │   └────◇───────────────────────────────◇
   │                    │ YES
   │        ┌───────────────────────────────────┐
   │        │   Reading time measuring counter   │──── S5
   │        └───────────────────────────────────┘
   │                    │
   │        ┌───────────────────────────────────┐
   │        │   Resetting peak hold              │──── S6
   │        └───────────────────────────────────┘
   │                    │
   │        ┌───────────────────────────────────┐
   │        │   Waiting for a few milliseconds   │──── S7
   │        └───────────────────────────────────┘
   │                    │
   │    ┌───────────────────────────────────────┐
   │    │   Capturing peak hold value into A/D converter │──── S8
   │    └───────────────────────────────────────┘
   │                    │
   │                    │              S9
   │          ◇───────────────────────◇               NO
   │          ◇   Is phase shift and amplitude ◇──────────────┐
   │          ◇   larger than preset value?    ◇              │
   │          ◇───────────────────────◇                       │
   │                    │ YES      S10                    S11  │
   │        ┌───────────────────────┐        ┌───────────────────────┐
   │        │  Detection signal = on │        │  Detectional signal = off │
   │        └───────────────────────┘        └───────────────────────┘
   │                    │                              │
   └────────────────────┴──────────────────────────────┘
```

Fig. 3

Forcedly oscillating wave    Freely oscillating wave

Point b

Point a

Ch1  10.0 V          M 20.0μs  A  Ch3 ∫  2.70 V
Ch3  5.00 V
                     9.200 %

Driving pulse signal

Fig. 4

Point b **1**

Point b **1**

Enlarged

Fig. 5

Point b [R]

Point b [R]

Metal in proximity
(7mm)

Enlarged

No metal

Fig. 6

Point b

Metal in proximity
(3mm)

Enlarged

Point b

No metal

Fig. 7

Fig. 8

Point b

Voltage level
without metal

Point b

Point c

Fig. 9

Fig. 10

No. n-3
phase shift

No. n-2
phase shift

No. n-1
phase shift

No. n
phase shift

No. n+1
phase shift

No. n+2
phase shift

Point c

Enlarged

Point b

Point c

Amplitude change

Metal in proximity
(3mm)

No metal

Fig. 11

EP 1 931 031 A1

Fig. 12

Number of freely oscillating waves counted:5
Number of times of regression operation:10

Amplified
phase shift

## Fig. 13

Start

Setting reference
voltage of comparator — S11

Clearing regression operation counter
/clearing time measuring counter — S12

Outputting several shots of driving pulse signals such
that maximum voltage is applied to both ends of detecting coil — S13

Clearing freely
oscillating wave counter — S14

Is freely oscillating
wave predetermined number? — S15
NO

YES

Regression operation counter +1 — S16

Is regression operation
counter predetermined number? — S17
NO

YES

Reading time measuring counter — S18

Transforming time measuring counter value into
predetermined detection signal format to output — S19

# Fig. 14

```
              ┌─────────────────────┐
              │        Start        │
              └─────────────────────┘
                        │
        ┌───────────────────────────────────────┐
        │  Setting reference voltage of comparator │──────── S21
        └───────────────────────────────────────┘
                        │
   ┌──────────────────────────────────────────────────┐
   │ Outputting several shots of driving pulse signals such that │──────── S22
   │ maximum voltage is applied to both ends of detecting coil   │
   └──────────────────────────────────────────────────┘
                        │
        ┌───────────────────────────────────────┐
        │  Clearing freely oscillating wave counter │──────── S23
        └───────────────────────────────────────┘
                        │
              ┌─────────────────────┐
     NO       │  Is freely oscillating wave  │──────── S24
      ◄───────│  counter predetermined number? │
              └─────────────────────┘
                        │ YES
        ┌───────────────────────────┐
        │      Resetting peak hold      │──────── S25
        └───────────────────────────┘
                        │
        ┌───────────────────────────┐
        │  Waiting for a few milliseconds │──────── S26
        └───────────────────────────┘
                        │
        ┌───────────────────────────┐
        │   Capturing peak hold value    │──────── S27
        │      into A/D converter       │
        └───────────────────────────┘
                        │
   ┌──────────────────────────────────────────┐
   │      Transforming peak hold value into       │──────── S28
   │ predetermined detection signal format to output │
   └──────────────────────────────────────────┘
```

Fig. 15

## INTERNATIONAL SEARCH REPORT

| International application No. |
|---|
| PCT/JP2006/317175 |

| A. CLASSIFICATION OF SUBJECT MATTER |
|---|
| *H03K17/95*(2006.01)i, *G01B7/00*(2006.01)i |

According to International Patent Classification (IPC) or to both national classification and IPC

| B. FIELDS SEARCHED |
|---|

Minimum documentation searched (classification system followed by classification symbols)
H03K17/74-17/98, G01B7/00

Documentation searched other than minimum documentation to the extent that such documents are included in the fields searched

| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

| C. DOCUMENTS CONSIDERED TO BE RELEVANT |
|---|

| Category* | Citation of document, with indication, where appropriate, of the relevant passages | Relevant to claim No. |
|---|---|---|
| X<br>A | JP 02-295222 A (Fuji Electric Co., Ltd.),<br>06 December, 1990 (06.12.90),<br>Figs. 2 to 3<br>(Family: none) | 1,8-12,17,18<br>2-5,13-15 |
| X<br>A | JP 02-501615 A (Andrae Leonberg GmbH),<br>31 May, 1990 (31.05.90),<br>Figs. 1 to 7<br>& EP 0311128 A1   & WO 1989/003615 A1<br>& DE 3733943 A   & DE 3871895 A | 1,8-12,17,18<br>2-5,13-15 |
| X<br>A | JP 02-050521 A (Asutekkusu Kabushiki Kaisha),<br>20 February, 1990 (20.02.90),<br>Figs. 1 to 3<br>(Family: none) | 1,8-12,17,18<br>2-5,13-15 |

| ☒ | Further documents are listed in the continuation of Box C. | ☐ | See patent family annex. |
|---|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 27 November, 2006 (27.11.06) | 05 December, 2006 (05.12.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

International application No.

PCT/JP2006/317175

C (Continuation).   DOCUMENTS CONSIDERED TO BE RELEVANT

| Category* | Citation of document, with indication, where appropriate, of the relevant passages | Relevant to claim No. |
|---|---|---|
| X<br>A | JP 64-029015 A  (La Telemecanique Electrique),<br>31 January, 1989 (31.01.89),<br>Figs. 1 to 7<br>& US 4893076 A1        & GB 2204135 A<br>& GB 8809359 A0        & DE 3813734 A<br>& FR 2614432 A         & CH 0675491 A<br>& IT 1216627 A         & IT 1216627 B | 1,8-12,17,18<br>2-5,13-15 |
| X<br>A | JP 02-501793 A  (Andrae Leonberg GmbH),<br>14 June, 1990 (14.06.90),<br>Figs. 1 to 2<br>& US 4985172 A1        & EP 0321504 A<br>& EP 0311129 A1        & WO 1988/003525 A1<br>& WO 1989/003616 A1    & DE 3638119 A<br>& DE 3733944 A         & DE 3775934 C<br>& DE 3775934 A         & DE 3638119 A1<br>& NO 0883048 A         & ES 2008763 A | 1,8-12,17,18<br>2-5,13-15 |

Form PCT/ISA/210 (continuation of second sheet) (April 2005)

## INTERNATIONAL SEARCH REPORT

| International application No. |
|---|
| PCT/JP2006/317175 |

**Box No. II      Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III      Observations where unity of invention is lacking (Continuation of item 3 of first sheet)**

This International Searching Authority found multiple inventions in this international application, as follows:
See extra sheet.

1. ☐ As all required additional search fees were timely paid by the applicant, this international search report covers all searchable claims.

2. ☐ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☒ No required additional search fees were timely paid by the applicant.   Consequently, this international search report is restricted to the invention first mentioned in the claims; it is covered by claims Nos.: 1-5, 8-15, 17, 18

**Remark on Protest**
the

☐ The additional search fees were accompanied by the applicant's protest and, where applicable, payment of a protest fee..

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (April 2005)

| INTERNATIONAL SEARCH REPORT | International application No. |
|---|---|
| | PCT/JP2006/317175 |

Continuation of Box No.III of continuation of first sheet(2)

A matter common to claims 1-18 is "outputting a drive signal to a resonating circuit consisting of a capacitor connected wit a detection coil, and detecting the proximity of metal based on the phase shift and/or the amplitude change of a free vibration wave output in a dampening manner from the resonating circuit after the output of the drive signal stops".

However, since the above matter is not novel as indicated in the prior art: Patent Laid Open Gazette No. H2-295222, Patent Indication Gazette No. H2-501615, it is not a special technical feature within the meaning of PCT Rule 13.2, second sentence.

Therefore, there is no matter common to all the claims. There exists no other common matter to be considered to be a special technical feature within the meaning of PCT Rule 13.2, second sentence, therefore no technical relationship within the meaning of PCT Rule 13 can be found among those different inventions.

Accordingly, the inventions in claims 1-18 do not fulfill the requirement of unity of invention.

In view of claims 1, 12 not making contribution over the prior art, the inventions in the claims are classified as follows and the number of invention in this International Application is two.

(1) C1-5, 8-15, 17, 18 (Represented by claims 2, 13. Inventions relating to a detection based on phase shift. C1, 12 are classified under (1) for convenience.)

(2) C6, 7, 16 (Inventions relating to a detection based on amplitude change.)

Form PCT/ISA/210 (extra sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 2550621 B